(19) Europäisches Patentamt
European Patent Office
Office européen des brevets

(11) EP 4 379 466 A1

(12) EUROPEAN PATENT APPLICATION

(43) Date of publication:
05.06.2024 Bulletin 2024/23

(21) Application number: 22210353.3

(22) Date of filing: 29.11.2022

(51) International Patent Classification (IPC):
$G03F\ 7/20^{(2006.01)}$  $G03F\ 9/00^{(2006.01)}$

(52) Cooperative Patent Classification (CPC):
G03F 9/708; G03F 7/70683; G03F 9/7076;
G03F 9/7088; G03F 9/7092

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: ASML Netherlands B.V.
5500 AH Veldhoven (NL)

(72) Inventors:
• HULSEBOS, Edo, Maria
5500 AH Veldhoven (NL)
• BIJNEN, Franciscus, Godefridus, Casper
5500 AH Veldhoven (NL)
• DAI, Jin
5500 AH Vedlhoven (NL)

(74) Representative: ASML Netherlands B.V.
Corporate Intellectual Property
P.O. Box 324
5500 AH Veldhoven (NL)

(54) **ALIGNMENT METHOD AND ASSOCIATED ALIGNMENT AND LITHOGRAPHIC APPARATUSES**

(57) Disclosed is a method of correcting position measurement data for an effect of a scan offset, the method comprising: obtaining position measurement data relating to an obliquely scanned measurement along an oblique scan direction over one or more alignment marks, each said one or more alignment marks comprising one or more first direction sub-marks for measurement in a first direction and one or more second direction sub-marks for measurement in a second direction different from said first direction; determining a signal amplitude imbalance metric from said position measurement data, the signal amplitude imbalance metric comprising a ratio of a signal amplitude metric in the first direction to a signal amplitude metric in the second direction; and correcting said position measurement data using said signal amplitude imbalance metric.

Fig. 6

**Description**

BACKGROUND

Field of the Invention

The present invention relates to methods and apparatus usable, for example, in the manufacture of devices by lithographic techniques, and to methods of manufacturing devices using lithographic techniques. The invention relates to metrology devices, and more specifically metrology devices used for measuring position such as alignment sensors and lithography apparatuses having such an alignment sensor.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor or alignment sensor (both terms are used synonymously), typically an optical position sensor.

The lithographic apparatus includes one or more alignment sensors by which positions of marks on a substrate can be measured accurately. Different types of marks and different types of alignment sensors are known from different manufacturers and different products of the same manufacturer. A type of sensor widely used in current lithographic apparatus is based on a self-referencing interferometer as described in US 6961116 (Den Boef et al.). Various enhancements and modifications of the position sensor have been developed, for example as disclosed in US2015261097A1. The contents of all of these publications are incorporated herein by reference.

It is increasingly desirable to reduce the size of alignment marks and the time to measure the alignment marks, as both reticle space and metrology time is at a premium in IC manufacture. Reducing the size of alignment marks reduces the scan length over the mark and results in an increased impact of neighboring structures on the aligned position. The measured position from such small marks, and particularly if measured at a desired speed and orientation to detect two position directions in one scan, suffers from poor reproducibility (repro) and accuracy, due to one or both of the short scan length and neighboring structure impact. It is desirable to improve repro and accuracy in measuring such marks.

SUMMARY OF THE INVENTION

The invention in a first aspect provides a method of correcting position measurement data for an effect of a scan offset, the method comprising: obtaining position measurement data relating to an obliquely scanned measurement along an oblique scan direction over one or more alignment marks, each said one or more alignment marks comprising one or more first direction sub-marks for measurement in a first direction and one or more second direction sub-marks for measurement in a second direction different from said first direction; determining a signal amplitude imbalance metric from said position measurement data, the signal amplitude imbalance metric comprising a ratio of a signal amplitude metric in the first direction to a signal amplitude metric in the second direction; and correcting said position measurement data using said signal amplitude imbalance metric.

The invention in a second aspect provides a substrate comprising one or more alignment marks configured for measurement along an oblique scan direction over said one or more alignment marks; wherein each said one or more alignment marks comprises one or more first direction sub-marks for measurement in a first direction and one or more second direction sub-marks for measurement in a second direction different from said first direction, the one or more first direction sub-marks each comprising first periodic structure having a direction of periodicity in said first direction and the one or more second direction sub-marks each comprising second periodic structure having a direction of periodicity in said second direction; wherein the first periodic structure and second periodic structure are non-continuous between any of said one or more first direction sub-marks and any of said one or more second direction sub-marks.

Also disclosed is a computer program, metrology apparatus and a lithographic apparatus being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 is a schematic illustration of a first alignment sensor adaptable according to an embodiment;
Figure 4 is a flowchart of a known alignment fit method;
Figure 5 is an illustrative example of the concept of lateral scan offset LSO;
Figure 6 is a plot of lateral scan offset LSO against wafer quality imbalance;
Figures 7(a) and 7(b) each depicts a respective different dual direction alignment mark according to embodiments; and
Figures 8(a) to 8(h) each depicts a respective different dual direction alignment mark according to embodiments.

DETAILED DESCRIPTION OF EMBODIMENTS

Before describing embodiments of the invention in detail, it is instructive to present an example environment in which embodiments of the present invention may be implemented.

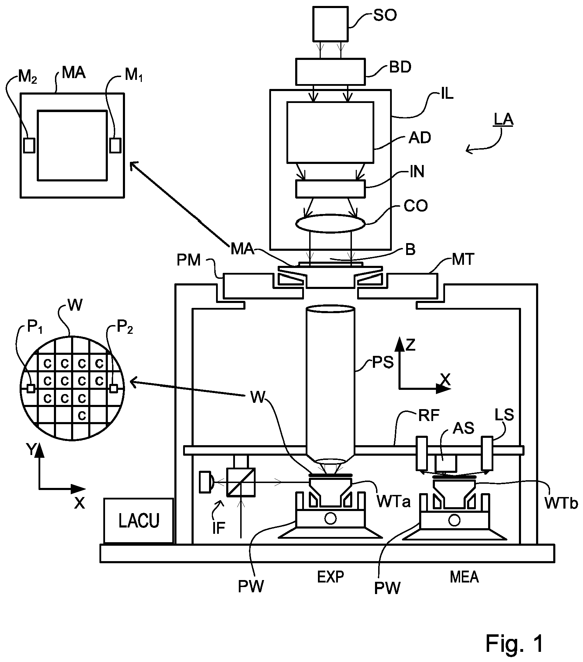

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

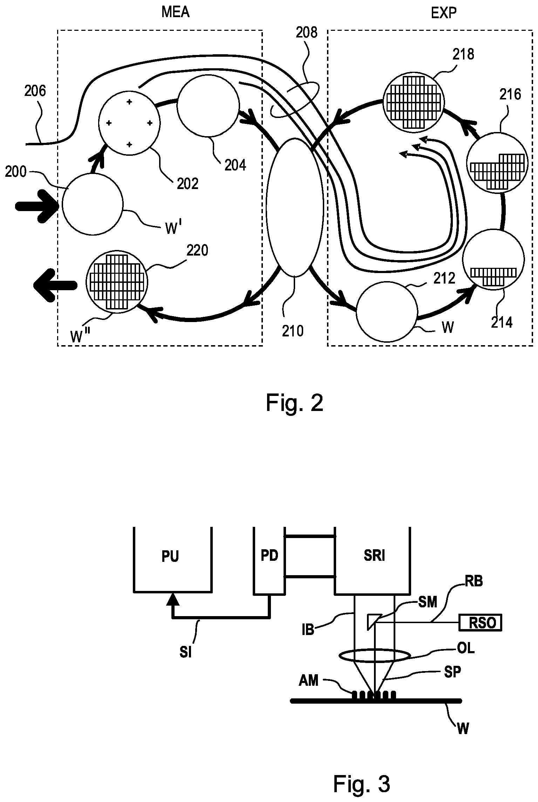

Figure 2 illustrates the steps to expose target portions (e.g., dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g., of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

In performing alignment by measuring the position of alignment marks on the substrate using an alignment sensor, it would be desirable to reduce the area (footprint) of the alignment marks, so that many of them could be accommodated all over the wafer; including in-die (e.g., between product structures) where wafer space is "expensive". It is therefore desirable, in a scanning-type alignment sensor (e.g., which scans an underfilled spot over the mark to generate a signal for the SRI), to reduce the length of the required scan length over the mark to maintain sufficient accuracy and reproducibility (repro). In addition to a regular periodic alignment mark, which provides a 1D position (X or Y) per scan, there is also the oblique mark which enables detection simultaneously in X and Y directions (e.g., both directions parallel to the substrate plane), thereby decreasing alignment time and increasing throughput. Such an oblique mark may comprise two segments with mark structures under +/- 45 degrees angle.

Presently, for spot underfilled marks, a fast Fourier transform (FFT)-based alignment fit (e.g., least squares fit) is used to determine the aligned position from the alignment signal. This is equivalent to performing a least squares fit of sine and cosine signals. The aligned position of the mark is calculated by determining the phase from the fitted sine and cosine signals and combining this with the average stage position during the scan.

With smaller marks, the sensor beam will not be incident fully on the alignment mark and therefore the alignment signal will not be perfectly periodic. The resulting signal is a periodic signal with a varying amplitude (or envelope) and with a varying DC component (or background signal).

In terms of overlay performance, there are several issues when using a periodic fit on such an alignment mark, among which include the reproducibility (repro) due to the envelope of the alignment signal, poor accuracy due to crosstalk effects from structures next to the alignment mark and (for multi pitch marks) poor repro due to crosstalk between the pitches, distinct in angle and/or pitch for dual period oblique marks. The repro of a dual pitch alignment marks is significantly worse than single pitch gratings, mainly due to mixing (cross-talk) between the two effective pitches, which for a dual pitch oblique mark enables calculation of the X and Y position. This is particularly the case for a short scan length (e.g., less than 20μm, less than 15μm or less than 12μm) over the alignment mark.

WO2021239461, which is incorporated herein by reference, described a method for performing a Background Envelope Periodic Fit (BEPF) to fit the measured alignment signal. The BEPF fit comprises a least-squares fit of multiple modulated sine, cosine and DC signals for all orders within the alignment signal. This concept is based on extending the periodic signal model with enveloped periodic signals and background signals. This allows the algorithm to deal with small mark signals without using filtering and modulation techniques. An extended model allows for oblique projection techniques to be used on the fit coefficients which can actively cancel out crosstalk disturbances on the alignment signal for specific adjacent structures and/or crosstalk between pitches of a dual direction mark. In the former case, the projection operator can be calibrated using simulations of the mark with adjacent specific crosstalk structures using an offline mark and sensor model simulation, or by means of actual measurement on such a mark. Therefore this approach can simultaneously address the issue of poor repro due to the envelope of the alignment signal and due to crosstalk between dual pitches and the issue of poor accuracy due to crosstalk effects from structures adjacent the alignment mark.

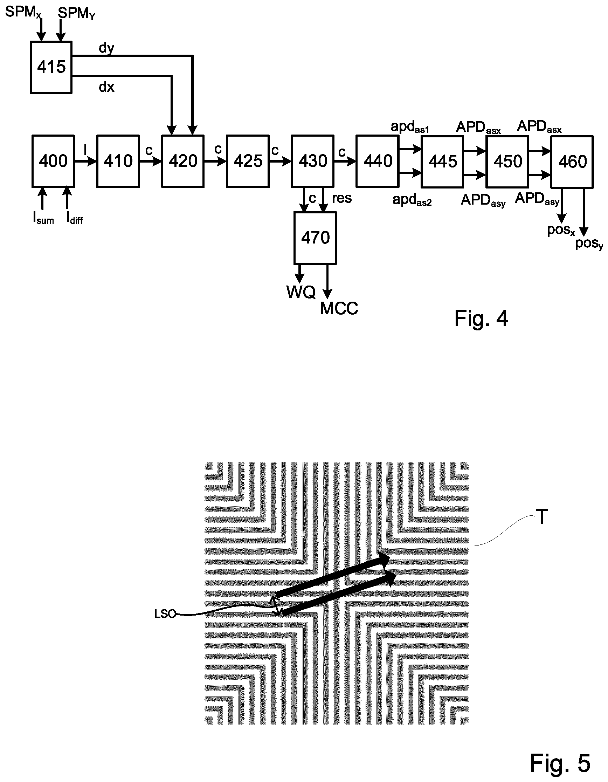

Figure 4 is a flowchart describing a BEPF fit according to a 2D embodiment. This method was described in WO2021239461, which can be referred to for further detail on some of the steps.

At step 400, the BEPF model matrices are calculated using a suitable model which enables the fitting of an arrangement of scan length multiples, pitch and order dependent cosines and sines of which the amplitudes are described by a set of parameters. The method may comprise a 2D fitting, although for brevity the specific examples will refer to one direction only (e.g., the x-direction). Application to the y-direction channel will be clear to the skilled person.

Two specific examples of models were described in WO2021239461:

$$I(x) \approx \alpha + \beta \frac{2x}{l_{scan}} + \sum_{b=1}^{\text{bg order}} \gamma_b \cos \frac{2\pi bx}{l_{scan}} + \delta_b \sin \frac{2\pi bx}{l_{scan}}$$

$$+ \sum_{o=1}^{\text{order}} \left( \varepsilon_o + \zeta_o \frac{2x}{l_{scan}} + \sum_{e}^{\text{env order}} \eta_{eo} \cos \frac{2\pi ex}{l_{scan}} + \theta_{eo} \sin \frac{2\pi ex}{l_{scan}} \right) \cdot \cos \frac{2\pi ox}{l_{baseperiod}}$$

$$+ \sum_{o=1}^{\text{order}} \left( \kappa_o + \lambda_o \frac{2x}{l_{scan}} + \sum_{e}^{\text{env order}} \mu_{eo} \cos \frac{2\pi ex}{l_{scan}} + \nu_{eo} \sin \frac{2\pi ex}{l_{scan}} \right) \cdot \sin \frac{2\pi ox}{l_{baseperiod}}$$

and:

$$I(x) \approx \alpha + \sum_{b=1}^{\frac{1}{2}N_{periods}-1} \beta_b \cos \frac{2\pi(b-\frac{1}{2})x}{L_{scan}} + \gamma_b \sin \frac{2\pi(b-\frac{1}{2})x}{L_{scan}} + \mu \cos \frac{\pi N_{periods} x}{L_{scan}} + \nu \sin \frac{\pi N_{periods} x}{L_{scan}}$$

$$+ \sum_{o} \left( \delta_o + \sum_{b=1}^{\frac{1}{2}N_{periods}-1} \varepsilon_{ob} \cos \frac{2\pi(b-\frac{1}{2})x}{L_{scan}} + \zeta_{ob} \sin \frac{2\pi(b-\frac{1}{2})x}{L_{scan}} \right) \cdot \cos \frac{2\pi ox}{L_{baseperiod}}$$

$$+ \sum_{o} \left( \eta_o + \sum_{b=1}^{\frac{1}{2}N_{periods}-1} \theta_{ob} \cos \frac{2\pi(b-\frac{1}{2})x}{L_{scan}} + \iota_{ob} \sin \frac{2\pi(b-\frac{1}{2})x}{L_{scan}} \right) \cdot \sin \frac{2\pi ox}{L_{baseperiod}}$$

The Model describes the background signal, the envelope and the periodic alignment signal by separate sets of parameters. More specifically, for each model:

- The first line is the background signal model comprising the DC and background terms (with model coefficients: $\alpha$, $\beta_b$, $\gamma_b$, including, in the second model, half order beat $\mu$, $\nu$).
- The second line contains envelope signals for the cosine part of the alignment signal (with model coefficients for the first model: $\delta_o$, $\zeta_o$, $\eta_{eo}$, $\theta_{eo}$, and for the second model: $\delta_o$, $\varepsilon_{ob}$, $\zeta_{ob}$).

- The third line contains envelope signals for the sine part of the alignment signal (with model coefficients for the first model: $\kappa_o$, $\lambda_o$, $\mu_{eo}$, $v_{eo}$, and for the second model: $\eta_o$, $\theta_{ob}$, $\iota_{ob}$).

The second of these models has orthogonal background and envelope functions and an improved overall condition number of the model matrix compared to the first model.

These models were specifically for a 1D implementation. For a 2D implementation, WO2021239461 described modifying the envelope model, because two orders are needed in the 2D fit in order to determine the two aligned positions in x and y. In such a case, the common base period of the two orders will often be too large such that only one or two base periods will fit within the scan length. The BEPF models in the form described above will therefore tend to result in no envelope model beyond DC. In the modified model, the concept of base period is abandoned and the maximum envelope order is based on the signal period rather than the common base period. As such, it was proposed that **the** envelope coefficient sin or cos $\left.{}^{2\pi ox}\middle/{}_{L_{baseperiod}}\right.$ be replaced by a coefficient based on the signal period, and that the maximum envelope order be allowed to be higher than the common base period such that the envelope may extend up to half of the actual signal period rather than half of the base period.

At step 410, an optional laser noise normalization LNN may be performed on the difference and sum signals $I_{diff}$, $I_{sum}$. This step may comprise the following sub-steps:

- Calculate background signal of $I_{diff}$ and $I_{sum}$ by using background model of BEPF;
- Normalize $I_{diff}$ and $I_{sum}$ with background signals;
- Calculate g factor (g) as the ratio of the RMS normalized $I_{diff}$ to the RMS normalized $I_{sum}$;
- Calculate normalized laser noise signal $=( I_{diff}+\text{g*}I_{sum})/(1+\text{g})$; and
- Divide original alignment signals $I_{diff}$ by laser noise signal (e.g., the normalized laser noise which is obtained from the ratio of the normalized difference and sum background signals from the BEPF model);

At step 420, a core fit of the BEPF is performed. The core fit algorithm may use the precalculated inverse matrix $\mathbf{M_{inv}}$ to calculate the fit coefficients (e.g., fitted signal $c_{as} = \mathbf{M_{inv}} \text{x} I$). This speeds up the calculation compared to a regular least squares fit algorithm.

A regularization may be applied at this step. In an embodiment, the regularization may comprise a second-order regularization to bias the fitting towards a solution with smooth envelope functions. More specifically, in an embodiment the regularization may take the form:

$$c = \arg\min_{c} \left\{ \left\| I - Mc \right\|^2 + \lambda \cdot \int_{x} \left| \frac{d^2 E_c(x)}{dx^2} \right|^2 dx \right\}$$

where $\lambda$ is the regularization parameter and $E_c(x)$ are the envelope signals of the model.

The regularization may be applied to the second order derivative of these envelope functions for both the orders and the background signal. As the envelope and background signal model comprises sums of cosine and sine functions, analytical expressions for the integral can be derived.

In an embodiment, and in particular with respect to the second model described, a stage position measurement ($\Delta$SPM) signal may be fitted, using the envelope model E. This may comprise a fitting of a position difference signal dx, dy determined (step 415) as a difference of the wafer stage position and a wafer stage setpoint signal (e.g., the expected position). This stage position measurement $\Delta$SPM signal describes the actual stage position with respect to an expected position (e.g., measured SPM minus the setpoint), such that the fitted $\Delta$SPM signal can be combined with the result of the core fit to yield an alignment signal. One reason for this is to allow for the fit coefficient rotation algorithm to work (see step 430 below). The core fit also calculates fit residual energy. After this step the raw alignment signal data is no longer needed. The fitting model for $\Delta$SPM may be substantially similar to the envelope or background model already described; e.g., :

$$\Delta SPM(x) = \alpha + \sum_{b=1}^{\frac{1}{2}N_{periods}-1} \beta_b \cos\frac{2\pi(b-\frac{1}{2})x}{L_{scan}} + \gamma_b \sin\frac{2\pi(b-\frac{1}{2})x}{L_{scan}}$$

In other embodiments, the stage position may be determined in other ways, as will be known to the skilled person.

At step 425, a correction step may be performed, which may comprise performing one or more of: Active Repro Correction (ARC), order leakage correction (OLC) and weak half order correction (WOC). Each of ARC, OLC and WOC is described in the aforementioned WO2021239461 and will not be described further here. Note that this step may be performed after the rotation step 430, or even split before and after rotation step 430; e.g., one or more of these corrections may be performed before step 430 and one or more of these corrections (e.g., not performed before) may be performed after this step. It is, however, simpler to perform ARC before step 430, on the non-rotated fit coefficients, although it could in theory be translated into a correction after rotation.

In step 430, a (e.g., 2D) fit coefficient rotation algorithm e.g., an oblique projection matrix may be applied; e.g., for crosstalk correction. The rotation step corrects for the fact that the expected position of the mark (i.e., where the scan is performed) does not match with the true position of the mark (i.e., the position being sought). The purpose of rotating the fit coefficients is to put the alignment scan approximately closer to the true mark location by moving it from the expected mark location to an approximate measured mark position. This is not a correction and in principle does not alter the aligned position, it only moves the center of the scan closer to the actual mark position.

At step 440, the APD signal is calculated from the phase sensitive relation of the constituent cosine and sine amplitude, as performed for regular Fourier fit, but taking into account the shape of the envelope expressed as a sum of sines and cosines ranging over a set of fractions of the scan length; the amplitudes being described by a set of parameters offset by a DC value; e.g., according to the following steps:

- Calculate envelope signals for use order; for the second model described, this may comprise:

$$E_{cos}(x) = \delta_o + \sum_{b=1}^{\frac{1}{2}N_{periods}-1} \varepsilon_{ob} \cos\frac{2\pi(b-\frac{1}{2})x}{L_{scan}} + \zeta_{ob} \sin\frac{2\pi(b-\frac{1}{2})x}{L_{scan}}$$

$$E_{sin}(x) = \eta_o + \sum_{b=1}^{\frac{1}{2}N_{periods}-1} \theta_{ob} \cos\frac{2\pi(b-\frac{1}{2})x}{L_{scan}} + \iota_{ob} \sin\frac{2\pi(b-\frac{1}{2})x}{L_{scan}}$$

- Calculate alignment sensor APD signal;

$$apd_{as}(x) = \frac{L_{baseperiod}}{2\pi} \cdot \mathrm{atan2}\big(-E_{sin}(x), -E_{cos}(x)\big)$$

The Y direction APD signal is determined in an equivalent manner, as should be clear.

Step 445 comprises a coordinate transform step to transform from the determined APD values from the oblique coordinate system to an X/Y (Cartesian) coordinate system. At step 450, a (e.g., fixed) Hann window may be applied to each channel. At step 460, the expected position (setpoint) in each direction may be added to the respective total APD for that channel, to determine the aligned position pos.

Optionally, at step 470, the BEPF fit allows for intra-mark key performance indicators (KPIs) to be determined, such as a maximum correntropy criterion (MCC subspaces); e.g., according to:

$$MCC = 1 - \left(\frac{Noise}{Signal}\right)^2$$

MCC may be mostly sensor noise only. Signal distortion may be included in MCC subspaces in addition to a total MCC.

Another KPI may be wafer quality (WQ) qualification. The raw WQ may be calculated by:

$$rawWQ = sqrt\big(mean(E_{cos.}^2 + E_{sin.}^2)\big); (\text{ Definition based on rms envelope})$$

$$rawWQ = \max\big(sqrt(E_{cos.}^2 + E_{sin.}^2)\big); (\text{Alternative definition based on max order}$$

signal envelope).

The 2D BEPF fit, in combination with 2D marks, is found to suffer from a scan offset impact. The fit is particularly sensitive to lateral scan offsets (LSO). Figure 5 illustrates the concept of LSO. An angled scan should be performed along a scan path with the measurement spot centered on the center of the target T, as indicated by the solid arrow. An offset LSO is the offset when the scan path is off-center (or offset from a reference position) as indicated by the broken arrow.

A method for addressing the LSO issue, disclosed in WO2021239461, was to determine a correction $\mathbf{c}_{corrected}$ for applying the fit coefficients $\mathbf{c}_{fitted}$, as described by lateral scan offset correction model:

$$\mathbf{c}_{corrected} = \mathbf{c}_{fitted} + \sum_{k} g_k(wq_{ord}) \cdot \sum_{n,m} \mathbf{d}_{knm} x_{lat}^n x_{long}^m$$

where $g_k$ is the scaling function which determines how the corrections scale with wafer quality $wq_{ord}$ of the fitted orders, $x_{lat}$ and $x_{long}$ are the lateral and longitudinal scan offset coordinates calculated from the 2D EPF fit and $\mathbf{d}_{knm}$ comprises the correction fit coefficients per scaling function and polynomial term for the scan offsets. Wafer quality $wq_{ord}$ is an example of a signal amplitude metric, which may be equal to the RMS signal amplitude or max order signal amplitude as has been described in relation to Step 470. However other signal amplitude metrics may be used.

In practice only a few polynomial terms for the scan offset coordinates $x_{lat}$ and $x_{long}$ are required, and because the aligned position of the scan is only affected by anti-symmetrical part of the lateral scan offset impact on the rotated alignment signal, the polynomial terms can be limited to antisymmetric only (i.e., $m + n$ is odd).

A calibration for $d_{knm}$ may be performed by performing scans with multiple scan offsets on multiple marks which capture the relevant sub-segmentation aspects, including WQ/signal amplitude imbalance and other mark properties which affect the lateral scan offset impact. An appropriate set of scaling function $g_k$ may be determined, e.g., for the weak half orders which are based on (e.g., scales with) the square root of the product of amplitudes $A_n$, $A_m$. The correction fit coefficients $\mathbf{d}_{knm}$ may be optimized for minimal variation of the rotated fit coefficients for all scan offsets and marks.

An LSO correction model will be described herein which provides better performance than the correction model described in WO2021239461 and recited above. Such an approach is based on a new parameter or KPI: wafer quality imbalance $wq_{imb}$ (or another signal amplitude imbalance metric). Wafer quality imbalance $wq_{imb}$ may be defined as the ratio of raw wafer quality in the x and y directions $wq_x$ $wq_y$:

$$wq_{imb} = \frac{wq_x}{wq_y}.$$

Wafer quality may be defined as elsewhere in the specification. As before, wafer quality is an example of a signal amplitude metric (e.g., a measure of the alignment signal amplitude), and other alternative signal amplitude metrics may be used. As such, any mention of wafer quality may be extended to any signal amplitude metric, and any mention of wafer quality imbalance may refer to a signal amplitude metric imbalance (e.g., ratio of a signal amplitude metric in a first direction of a substrate plane to a signal amplitude metric in a second direction of a substrate plane, the first and second directions being mutually perpendicular).

The proposed model, which determined a corrected position measurement data or alignment signal $apd_{corrected}$ (where apd is an abbreviation of aligned position deviation, i.e., a position deviation with respect to a nominal grid position) may comprise:

$$apd_{corrected} = apd_{meas} + \sum_{n,m} P_{mn} x_{lat}^m x_{long}^n$$

$$+ \begin{cases} |wq_{imb} - wq_{imb-th}| \cdot \sum_{m,n} Q_{mn} x_{lat}^m x_{long}^n & \text{for } (wq_{imb} - wq_{imb-th}) \geq 0 \\ |wq_{imb} - wq_{imb-th}| \cdot \sum_{m,n} R_{mn} x_{lat}^m x_{long}^n & \text{for } (wq_{imb} - wq_{imb-th}) < 0 \end{cases}$$

where $apd_{meas}$ is the measured position measurement data or alignment signal, $x_{lat}$ and $x_{long}$ are the lateral and longitudinal scan offset coordinates calculated from the 2D EPF fit, $wq_{imb-th}$ is a wafer quality imbalance threshold and $P_{mn}$, $Q_{mn}$, $R_{mn}$ are calibrated parameters/matrices; these may be calibrated in an initial calibration step. As such, the actual model applied is different depending on whether or not the difference of the signal amplitude imbalance metric $wq_{imb}$

and said signal amplitude imbalance metric threshold value $wq_{imb\text{-}th}$ is less than zero. It can be appreciated that the alignment signal or apd is corrected directly using this model, rather than correcting the fit coefficients, as was the case with the model described in WO2021239461.

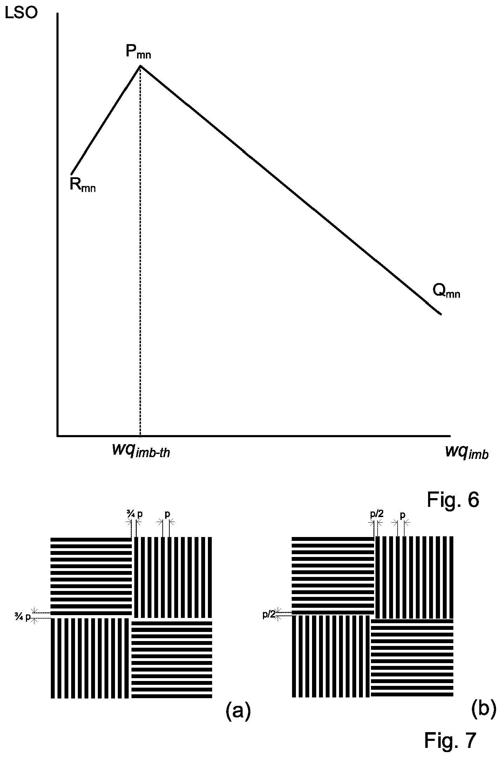

Figure 6 is a plot of LSO against wafer imbalance $wq_{imb}$, which aids explanation of the relationships described by this model. As can be seen, LSO shows two opposite sloped linear dependencies on wafer imbalance $wq_{imb}$: a positive linear slope at the left side of the wafer quality imbalance threshold $wq_{imb\text{-}th}$ and a negative linear slope at the right side of this threshold.

The matrices $P_{mn}$, $Q_{mn}$, $R_{mn}$ may be calibrated by performing a plurality of calibration measurements or calibration scans (e.g., in a calibration phase), on a plurality of calibration alignment marks, with LSO varied over the scans. The calibration alignment marks should comprise various types of sub-segmentations or other variations, such that these variations capture the relevant WQ imbalance aspects. For example, a plot of LSO against WQ imbalance from such calibration scans should resemble the plot of Figure 6. This calibration does not need to be performed separately for each stack; only one calibration per lithographic apparatus (e.g., scanner) should be sufficient.

The original LSO correction model disclosed in WO2021239461 was described in the context of measurement of an alignment mark such as illustrated in Figure 9 of that specification (and Figure 5 of this specification). The model disclosed herein may not perform so well with such an alignment mark. As such, a number of alternative alignment mark designs will now be described, which demonstrate improved performance in combination with a wafer quality imbalance based the LSO correction model. In addition, many of these alignment marks also inherently reduce the LSO impact.

Each of these alignment marks comprise dual direction alignment marks (i.e., for simultaneous measurement in mutually perpendicular first and second directions) and are configured for measurement via a single angled (oblique) scan, where an angled or oblique scan comprises a scan at a scan angle different from (i.e., oblique to) the first and second directions. Where the X and Y sub-marks have the same pitch, the oblique scan angle may be angle other than 45 degrees such the X and Y components of the signal data or position measurement data can be differentiated based on their effective pitch along the scan path. The scan angle may be such that the detection pitch ratio (effective pitch ratio) X:Y is 2:3; for sub-marks of equal pitch this angle may be between 33 degrees and 34 degrees (e.g., 33.7 degrees). More generally, the scan angle may be for example between 10 degrees and 40 degrees, between 20 degrees and 40 degrees, between 25 degrees and 40 degrees, between 25 degrees and 35 degrees or between 30 degrees and 35 degrees.

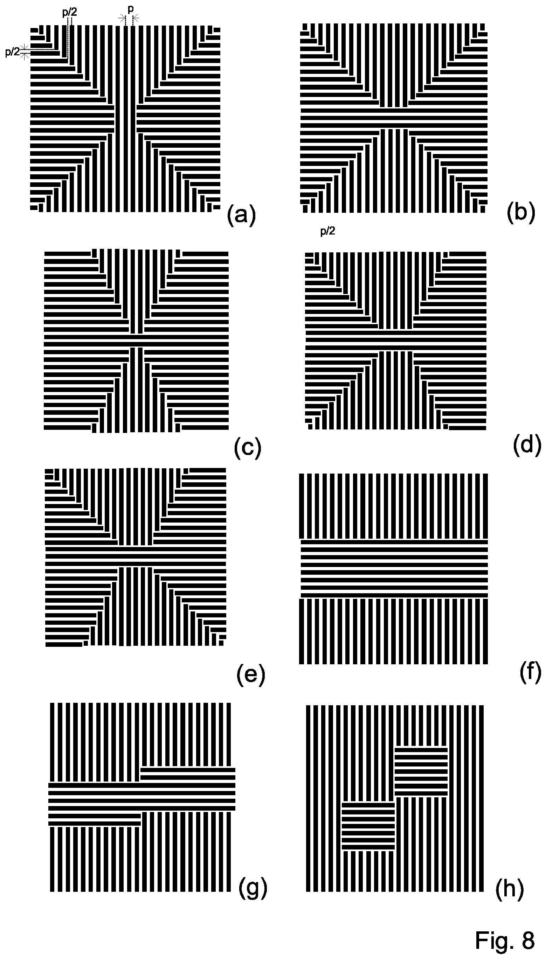

If the pitch in X and Y is allowed to differ within a target, it is possible to detect over a larger set of scan angles including at 45 degrees. By way of a specific example, with reference to the target design of Figure 8(c) (which will be described below), it can be seen that the Y-direction pitch may be doubled with respect to the X-direction pitch, without further changing the design. In such a case, the detection angle case could be 45 degrees. This applies equally to the designs of Figures 8(f), (g) and (h) could also allow for pitch changes between X and Y (not restricted by factor 2 difference).

Of particular note is that, in each case and in contrast to the aforementioned alignment mark design, the lines which form the X and Y segments are not connected.

Figure 7 shows two variations which resemble "micro-diffraction based overlay (μDBO)" targets which are a known design for overlay metrology. For overlay, such targets will comprise two overlaid gratings per sub-target, such that a relative displacement (i.e., overlay) between the overlaid gratings in a different respective layer can be measured. For alignment, the proposed marks may comprise only a single grating (i.e., in a single layer) per sub-mark. Each alignment mark comprises a pair of sub-marks per direction (e.g., arranged in a 2x2 array), each sub-mark of a pair being in diagonally opposing quadrants. As such, a pair of first direction sub-marks may be comprised in a first pair of diagonally opposing quadrants and said pair of second direction sub-marks may be comprised in a second pair of diagonally opposing quadrants. Each sub-mark may be rectangular (e.g., square or oblong).

The alignment mark in Figure 7(a) has a larger (e.g., larger than half-pitch, such as a three-quarter-pitch) spacing between the different sub-marks compared to the alignment mark of Figure 7(b). As such, the distance between X direction features (e.g., grating lines) and adjacent Y direction features is three-quarter-pitch (i.e., each distance where a line end in one direction is adjacent a line of the other direction). The pitch p refers to the grating pitch of the sub-marks and may be defined as the distance between line centers of adjacent lines. For the alignment mark of Figure 7(b) this spacing is smaller, e.g., smaller than full pitch, smaller than three-quarter pitch or approximately half-pitch. In this latter case, lateral scan offset is even more strongly reduced by design due to this smaller (e.g., half pitch) distance between the line end of a sub-mark with respect to the grating line center of the adjacent sub-mark of other orientation.

Figure 8 illustrates a number of different alignment marks measurable according to embodiments. Figures 8(a) to 8(e) show a mark design similar to the prior art mark design of Figure 5. However, in contrast to the prior art mark, each of these marks have unconnected or non-continuous grating lines between the two directions. This may be defined as where the grating lines in a first direction are non-continuous (do not connect or touch) with the grating lines in a second direction. These marks may be more compatible (e.g., in terms of process compatibility) with present measurement processes if being used in place of the prior art marks such as illustrated in Figure 5.

In the specific examples shown, at any interface where a feature end or line end of a sub-mark of a first direction is adjacent a feature/line of a sub-mark of the second direction, the distance between that line end (of the line of the first direction) with respect to the grating line center of the adjacent line of the second direction is half-pitch p/2. This is explicitly shown on Figure 8(a), but equally applicable for each of the marks shown in this Figure. More generally, as before, this distance may be full pitch, larger than half-pitch (e.g., approximately three-quarter-pitch), smaller than three-quarter-pitch or approximately half-pitch.

Figures 8(a) and 8(b) comprise essentially the same mark but at different orientations. In each case, the mark comprises two pairs of substantially triangular sub-marks (e.g., isosceles triangular), or an approximation thereof, arranged to make a square or oblong alignment mark. Each pair of sub-marks comprises gratings of a respective different direction, each sub-mark of a pair being aligned along opposite sides of the mark (e.g., such that each sub-mark of a pair of first direction sub-marks are aligned along a first pair of opposite sides of the alignment mark and each sub-mark of a pair of second direction sub-marks being aligned along a second pair of opposite sides of the alignment mark. One of the pairs of sub-marks may be continuous through the alignment mark center, e.g., such that a central portion of the gratings in one direction extends continuously over the pair of sub-marks. As a result, this pair of sub-marks may technically comprise a single "bow-tie" shaped sub-mark and the other pair of sub-marks may have a flattened apex (e.g., such that each is technically quadrilateral).

Figure 8(c) shows a mark similar to that illustrated in Figure 8(b), but where one pair of sub-marks is reduced in width (e.g., to half the mark width) and centered on the mark edge (e.g., such that their apexes are aligned with the mark center). As before, one pair of sub-marks may be continuous. For example, the continuous pair of marks may comprise the larger pair of marks. A 90 degree rotated version of this mark is also possible (e.g., in equivalence to Figure 8(b) with respect to Figure 8(a).

Figure 8(d) shows a mark which is essentially a combination of the mark concepts of the marks illustrated in Figure 8(b) and 8(c). In this manner, the mark is essentially asymmetric around (at least) one (substrate-plane) axis through the mark center. The mark may comprise (in essence) a combination of a first half of the mark Figure 8(b) and a second half of the mark Figure 8(c). As such, one pair of sub-marks may each be substantially scalene triangular (technically quadrilateral due to the flattened top), with a base aligned along over half of the mark width, but not the full width (e.g., along substantially three-quarters of the mark width), beginning at one mark corner. The other pair of sub-marks may again be continuous, and each comprise a sub-mark of a different respective shape. This target may be reversed or oriented at 90 or 270 degrees.

Figure 8(e) is similar to the mark of Figure 8(b), but where one half of the mark (e.g., the bottom half) is mirror-reversed. This mark is therefore asymmetric around each substrate-plane axis through the mark center. As before, this target may be reversed or oriented at 90 or 270 degrees.

Figures 8(f)-8(h) show other possible alignment mark arrangements comprising two or more sub-marks, i.e., at least one sub-mark per direction with lines of one direction separated/unconnected to the lines of the other direction.

Figure 8(f) shows a mark comprising a pair of sub-marks of a first direction separated by a sub-mark of a second direction. The sub-mark of the second direction extends across the center of the mark. Each of the sub-marks may comprise approximately a third of the mark (e.g., top third, middle third and bottom third). Figure 8(g) is a variation on this, where a bottom portion of the central (unpaired) sub-mark only extends across a first half of the mark width and a top portion of the central sub-mark only extends across a second half of the mark. Figure 8(h) shows a mark comprising a sub-mark of a first direction over much of its area, and a pair of sub-marks in a second direction within a central region, the pair of sub-marks having diagonally opposite corners at the target center.

Note that many design variations are possible for all of the alignment marks, which may include, for example *inter alia:* reversing the directions of the respective sub-marks within each mark, rotating each mark through 90, 180 or 270 degrees and/or reversing it across a central axis, having a different width (e.g., number of lines) in the continuous regions through the center of some of the marks.

All the example embodiments of Figures 7 and 8 show alignment marks with a common pitch for the X and Y sub-marks. As has been already stated, this is not necessary and the pitches can be different for the X and Y sub-marks. This can allow for a greater range of scan angles, including scanning at 45 degrees. Where the pitches differ, the separation between the sub-marks of different directions may be half the smallest pitch (or optionally half the largest pitch).

In all examples of alignment marks disclosed herein, the alignment marks may be smaller than $100\mu$m, smaller than $80\mu$m, smaller than $70\mu$m, smaller than $60\mu$m, smaller than $55\mu$m, or smaller than or equal to $50\mu$m in one or both of the substrate plane directions.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Aspects of the invention are set out in the clauses below.

1. A method of correcting position measurement data for an effect of a scan offset, the method comprising: obtaining position measurement data relating to an obliquely scanned measurement along an oblique scan direction over one or more alignment marks, each said one or more alignment marks comprising one or more first direction sub-marks for measurement in a first direction and one or more second direction sub-marks for measurement in a second direction different from said first direction; determining a signal amplitude imbalance metric from said position measurement data, the signal amplitude imbalance metric comprising a ratio of a signal amplitude metric in the first direction to a signal amplitude metric in the second direction; and correcting said position measurement data using said signal amplitude imbalance metric.

2. A method according to clause 1, wherein said signal amplitude imbalance metric comprises wafer quality imbalance, comprising a ratio of wafer quality in the first direction to wafer quality in the second direction.

3. A method according to clause 1 or 2, wherein said signal amplitude metric is determined as a root-mean-square of the signal amplitude or max order of the signal amplitude.

4. A method according to any preceding clause, wherein said correcting step comprises applying a model to the position measurement data, the model describing a relationship between said scan offset and said signal amplitude imbalance metric.

5. A method according to clause 4, wherein said model describes two oppositely sloped substantially linear relationships either side of a signal amplitude imbalance metric threshold value.

6. A method according to clause 4 or 5, wherein said model uses a difference of said signal amplitude imbalance metric and said signal amplitude imbalance metric threshold value.

7. A method according to clause 6, wherein the model applied is different depending on whether or not said difference is less than zero.

8. A method according to any of clauses 4 to 7, comprising performing an initial calibration to calibrate said model, the initial calibration comprising performing a plurality of calibration measurements with different scan offsets on one or more calibration alignment marks.

9. A method according to clause 8, wherein said plurality of calibration alignment marks comprise a variation in the type of calibration alignment marks.

10. A method according to any preceding clause, wherein the one or more first direction sub-marks each comprises first periodic structure having a direction of periodicity in said first direction and the one or more second direction sub-marks each comprises second periodic structure having a direction of periodicity in said second direction; and wherein the first periodic structure and the second periodic structure are non-continuous between any of said one or more first direction sub-marks and any of said one or more second direction sub-marks.

11. A method according to clause 10, wherein said one or more first direction sub-marks and said one or more second direction sub-marks are substantially non-overlapping.

12. A method according to clause 10 or 11, wherein said one or more first direction sub-marks comprises a pair of first direction sub-marks and said one or more second direction sub-marks comprises a pair of second direction sub-marks.

13. A method according to clause 12, wherein said sub-marks are arranged in a 2x2 array, with said pair of first direction sub-marks being in a first pair of diagonally opposing quadrants and said pair of second direction sub-marks being in a second pair of diagonally opposing quadrants.

14. A method according to clause 12 or 13, wherein each sub-mark is rectangular.

15. A method according to any of clauses 12 to 14, wherein, where a feature end of a first direction sub-mark is adjacent a feature of a second direction sub-mark, the distance between that feature end with respect to the grating line center of the adjacent line is larger than half a pitch of the sub-marks or of the smallest pitch of the sub-marks.

16. A method according to any of clauses 12 to 15, wherein, where a feature end of a first direction sub-mark is adjacent a feature of a second direction sub-mark, the distance between that feature end with respect to the grating line center of the adjacent line is smaller than three-quarters a pitch of the sub-marks or of the smallest pitch of the sub-marks.

17. A method according to any of clauses 12 to 14, wherein, where a feature end of a first direction sub-mark is adjacent a feature of a second direction sub-mark, the distance between that feature end with respect to the grating line center of the adjacent line is substantially half the pitch of the sub-marks or of the smallest pitch of the sub-marks.

18. A method according to clause 12, wherein each sub-mark is substantially triangular or an approximation thereof, arranged to form a rectangular alignment mark, each sub-mark of the pair of first direction sub-marks being aligned along a first pair of opposite sides of the alignment mark and each sub-mark of the pair of second direction sub-marks being aligned along a second pair of opposite sides of the alignment mark.

19. A method according to clause 18, wherein at least some of the periodic structure of one of said pairs of sub-marks is continuous through the alignment mark center.

20. A method according to clause 18 or 19, wherein each of said sub-targets extends along substantially a full length of a respective edge of said alignment mark.

21. A method according to clause 18 or 19, wherein the sub-targets of one of said pairs of sub-targets extends along less than the full length of a respective edge of said alignment mark.

22. A method according to clause 21, wherein the sub-targets of one of said pairs of sub-targets extends along approximately half of the length of a respective edge of said alignment mark and is substantially centered on that respective edge.

23. A method according to clause 21, wherein the sub-targets of one of said pairs of sub-targets extends along approximately three-quarters of the length of a respective edge of said alignment mark and is aligned with a respective corner of the alignment mark.

24. A method according to clause 10 or 11, wherein said one or more first direction sub-marks comprises a pair of first direction sub-marks and said one or more second direction sub-marks comprises a single second direction sub-mark, the second direction sub-mark extending across the center of the mark, between each sub-mark of said pair of first direction sub-marks.

25. A method according to clause 24, wherein each of the sub-marks comprises approximately a third of the alignment mark.

26. A method according to clause 24 or 25, wherein a bottom portion of the second direction sub-mark only extends across a first half of the alignment mark and a top portion of the second direction sub-mark only extends across a second half of the alignment mark.

27. A method according to clause 10 or 11, wherein said one or more second direction sub-marks comprises a pair of second direction sub-marks located within a central region of the alignment mark, the pair of second direction sub-marks having diagonally opposite corners at a target center; and wherein the one or more first direction sub-marks comprises substantially the remainder of the alignment mark.

28. A method according to any of clauses 10 to 27, wherein each said one or more alignment marks is substantially rectangular.

29. A method according to any preceding clause, wherein a first direction component of the position measurement data is differentiated from a second direction component of the position measurement data by having a different effective pitch in the scan direction.

30. A method according to any preceding clause, wherein said obtaining position measurement data comprises obtaining signal data from said measurement, and fitting the signal data using a background envelope periodic fit.

31. A method according to clause 30, wherein said correcting step comprises determining lateral and longitudinal scan offset coordinates from the background envelope periodic fit; and using the determined lateral and longitudinal scan offset coordinates in correcting said position measurement data.

32. A method according to clause 30 or 31, wherein the background envelope periodic fit comprises extending a periodic signal model describing the position measurement data with enveloped periodic signals and background signals.

33. A method according to any of clauses 30 to 32, wherein said background envelope periodic fit comprises a fit of multiple modulated sine, cosine and DC signals for all orders within the signal data.

34. A method according to clause 33, wherein said fit of multiple modulated sine, cosine and DC signals comprises a least-squares fit.

35. A method according to any of clauses 30 to 34, comprising regularizing said background envelope periodic fit so as to bias the fitting towards a solution with smooth envelope functions.

36. A method according to any preceding clause, comprising performing a position measurement to obtain said position measurement data, the position measurement comprising scanning each said one or more alignment marks obliquely to the first direction and second direction.

37. A method according to clause 36, comprising the steps of: scanning a measurement beam over at least a portion of said alignment mark; and detecting said scattered radiation, scattered by the alignment mark to obtain said position measurement data.

38. A method according to any preceding clause, wherein the length of the scan in said scanning step is less than

15μm.

39. A computer program comprising computer readable instruction operable to perform the method of any of clauses 1 to 38.

40. A processor and associated storage medium, said storage medium comprising the computer program of clause 39 such that said processor is operable to perform the method of any of clauses 1 to 38.

41. A metrology device comprising the processor and associated storage medium of clause 40, the metrology device being operable to perform the method of any of clauses 36 or 38.

42. A lithographic apparatus comprising the metrology device of clause 41.

43. A lithographic apparatus according to clause 42, comprising: a patterning device support for supporting a patterning device; a substrate support for supporting a substrate; and wherein the metrology device is operable to determine an aligned position for one or both of the patterning device support and substrate support.

44. A substrate comprising one or more alignment marks configured for measurement along an oblique scan direction over said one or more alignment marks; wherein each said one or more alignment marks comprises one or more first direction sub-marks for measurement in a first direction and one or more second direction sub-marks for measurement in a second direction different from said first direction, the one or more first direction sub-marks each comprising first periodic structure having a direction of periodicity in said first direction and the one or more second direction sub-marks each comprising second periodic structure having a direction of periodicity in said second direction; wherein the first periodic structure and second periodic structure are non-continuous between any of said one or more first direction sub-marks and any of said one or more second direction sub-marks.

45. A substrate according to clause 44, wherein said one or more first direction sub-marks and said one or more second direction sub-marks are substantially non-overlapping.

46. A substrate according to clause 44 or 45, wherein said one or more first direction sub-marks comprises a pair of first direction sub-marks and said one or more second direction sub-marks comprises a pair of second direction sub-marks.

47. A substrate according to clause 46, wherein said sub-marks are arranged in a 2x2 array, with said pair of first direction sub-marks being in a first pair of diagonally opposing quadrants and said pair of second direction sub-marks being in a second pair of diagonally opposing quadrants.

48. A substrate according to clause 46 or 47, wherein each sub-mark is rectangular.

49. A substrate according to any of clauses 46 to 48, wherein a spacing between adjacent sub-marks is larger than half a pitch of the sub-marks.

50. A substrate according to any of clauses 46 to 49, wherein a spacing between adjacent sub-marks is smaller than three-quarters a pitch of the sub-marks.

51. A substrate according to any of clauses 46 to 48, wherein a spacing between adjacent sub-marks is substantially half the pitch of the sub-marks.

52. A substrate according to clause 46, wherein each sub-mark is substantially triangular or an approximation thereof, arranged to form a rectangular alignment mark, each sub-mark of the pair of first direction sub-marks being aligned along a first pair of opposite sides of the alignment mark and each sub-mark of the pair of second direction sub-marks being aligned along a second pair of opposite sides of the alignment mark.

53. A substrate according to clause 52, wherein at least some of the periodic structure of one of said pairs of sub-marks is continuous through the alignment mark center.

54. A substrate according to clause 52 or 53, wherein each of said sub-targets extends along substantially a full length of a respective edge of said alignment mark.

55. A substrate according to clause 52 or 53, wherein the sub-targets of one of said pairs of sub-targets extends along less than the full length of a respective edge of said alignment mark.

56. A substrate according to clause 55, wherein the sub-targets of one of said pairs of sub-targets extends along approximately half of the length of a respective edge of said alignment mark and is substantially centered on that respective edge.

57. A substrate according to clause 55, wherein the sub-targets of one of said pairs of sub-targets extends along approximately three-quarters of the length of a respective edge of said alignment mark and is aligned with a respective corner of the alignment mark.

58. A substrate according to clause 44 or 45, wherein said one or more first direction sub-marks comprises a pair of first direction sub-marks and said one or more second direction sub-marks comprises a single second direction sub-mark, the second direction sub-mark extending across the center of the mark, between each sub-mark of said pair of first direction sub-marks.

59. A substrate according to clause 58, wherein each of the sub-marks comprises approximately a third of the alignment mark.

60. A substrate according to clause 58 or 59, wherein a bottom portion of the second direction sub-mark only extends across a first half of the alignment mark and a top portion of the second direction sub-mark only extends across a second half of the alignment mark.

61. A substrate according to clause 44 or 45, wherein said one or more second direction sub-marks comprises a pair of second direction sub-marks located within a central region of the alignment mark, the pair of second direction sub-marks having diagonally opposite corners at a target center; and wherein the one or more first direction sub-marks comprises substantially the remainder of the alignment mark.

62. A substrate according to any of clauses 44 to 61, wherein each said one or more alignment marks is substantially rectangular.

63. A substrate according to any of clauses 44 to 62, wherein each said one or more alignment marks is smaller than $80\mu$m in said first direction and/or in said second direction.

64. A substrate according to any of clauses 44 to 62, wherein each said one or more alignment marks is smaller than $60\mu$m in said first direction and/or in said second direction.

65. A reticle comprising one or more patterns operable to pattern a substrate to obtain the substrate of any of clauses 44 to 64.

The breadth and scope of the present invention should not be limited by any of the above-described exemplary embodiments, but should be defined only in accordance with the following claims and their equivalents.

**Claims**

1. A method of correcting position measurement data for an effect of a scan offset, the method comprising:

   obtaining position measurement data relating to an obliquely scanned measurement along an oblique scan direction over one or more alignment marks, each said one or more alignment marks comprising one or more first direction sub-marks for measurement in a first direction and one or more second direction sub-marks for measurement in a second direction different from said first direction;
   determining a signal amplitude imbalance metric from said position measurement data, the signal amplitude imbalance metric comprising a ratio of a signal amplitude metric in the first direction to a signal amplitude metric in the second direction; and
   correcting said position measurement data using said signal amplitude imbalance metric.

2. A method as claimed in claim 1, wherein said signal amplitude imbalance metric comprises wafer quality imbalance, comprising a ratio of wafer quality in the first direction to wafer quality in the second direction.

3. A method as claimed in claim 1 or 2, wherein said signal amplitude metric is determined as a root-mean-square of the signal amplitude or max order of the signal amplitude.

4. A method as claimed in any preceding claim, wherein said correcting step comprises applying a model to the position measurement data, the model describing a relationship between said scan offset and said signal amplitude imbalance metric.

5. A method as claimed in any preceding claim, wherein the one or more first direction sub-marks each comprises first periodic structure having a direction of periodicity in said first direction and the one or more second direction sub-marks each comprises second periodic structure having a direction of periodicity in said second direction; and wherein the first periodic structure and the second periodic structure are non-continuous between any of said one or more first direction sub-marks and any of said one or more second direction sub-marks.

6. A method as claimed in claim 5, wherein said one or more first direction sub-marks and said one or more second direction sub-marks are substantially non-overlapping.

7. A method as claimed in claim 5 or 6, wherein said one or more first direction sub-marks comprises a pair of first direction sub-marks and said one or more second direction sub-marks comprises a pair of second direction sub-marks.

8. A method as claimed in any preceding claim, wherein said obtaining position measurement data comprises obtaining signal data from said measurement, and fitting the signal data using a background envelope periodic fit.

9. A method as claimed in claim 8, wherein said correcting step comprises determining lateral and longitudinal scan

**EP 4 379 466 A1**

offset coordinates from the background envelope periodic fit; and

using the determined lateral and longitudinal scan offset coordinates in correcting said position measurement data.

10. A substrate comprising one or more alignment marks configured for measurement along an oblique scan direction over said one or more alignment marks;

wherein each said one or more alignment marks comprises one or more first direction sub-marks for measurement in a first direction and one or more second direction sub-marks for measurement in a second direction different from said first direction, the one or more first direction sub-marks each comprising first periodic structure having a direction of periodicity in said first direction and the one or more second direction sub-marks each comprising second periodic structure having a direction of periodicity in said second direction;

wherein the first periodic structure and second periodic structure are non-continuous between any of said one or more first direction sub-marks and any of said one or more second direction sub-marks.

11. A substrate as claimed in claim 10, wherein said one or more first direction sub-marks and said one or more second direction sub-marks are substantially non-overlapping.

12. A substrate as claimed in claim 10 or 11, wherein said one or more first direction sub-marks comprises a pair of first direction sub-marks and said one or more second direction sub-marks comprises a pair of second direction sub-marks.

13. A substrate as claimed in claim 12, wherein each sub-mark is substantially triangular or an approximation thereof, arranged to form a rectangular alignment mark, each sub-mark of the pair of first direction sub-marks being aligned along a first pair of opposite sides of the alignment mark and each sub-mark of the pair of second direction sub-marks being aligned along a second pair of opposite sides of the alignment mark.

14. A substrate as claimed in claim 13, wherein at least some of the periodic structure of one of said pairs of sub-marks is continuous through the alignment mark center.

15. A reticle comprising one or more patterns operable to pattern a substrate to obtain the substrate of any of claims 10 to 14.

17

Fig. 1

Fig. 2

Fig. 3

SPM$_x$ SPM$_Y$

Fig. 4

Fig. 5

Fig. 6

(a)

(b)

Fig. 7

Fig. 8

Europäisches
Patentamt

European
Patent Office

Office européen
des brevets

# EUROPEAN SEARCH REPORT

Application Number

EP 22 21 0353

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/193039 A1 (ASML NETHERLANDS BV [NL]) 1 October 2020 (2020-10-01) | 10-12 | INV. G03F7/20 G03F9/00 |
| Y | * paragraphs [0059] - [0075]; figures 6,7 | 15 | |
| A | * | 1-9,13, 14 | |
| | * paragraphs [0080] - [0088]; figures 9,10 * | | |
| | ----- | | |
| X | KR 2006 0025459 A (HYNIX SEMICONDUCTOR INC [KR]) 21 March 2006 (2006-03-21) | 10,15 | |
| Y | * abstract * | 15 | |
| | * page 1; figures 2a,2b * | | |
| | ----- | | |
| A,D | WO 2021/239461 A1 (ASML NETHERLANDS BV [NL]) 2 December 2021 (2021-12-02) | 1-15 | |
| | * paragraphs [0058] - [0082] * | | |
| | * paragraphs [0098] - [0100]; claims 7,8; figures 6-9 * | | |
| | ----- | | |
| A | US 2006/061743 A1 (DEN BOEF ARIE J [NL] ET AL) 23 March 2006 (2006-03-23) | 1,10 | |
| | * paragraph [14.24]; figures 3-13 * | | |
| | ----- | | |

TECHNICAL FIELDS
SEARCHED       (IPC)

G03F

The present search report has been drawn up for all claims

| Place of search | Date of completion of the search | Examiner |
|---|---|---|
| Munich | 26 April 2023 | van Toledo, Wiebo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...............................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 21 0353

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2023

| Patent document cited in search report | | Publication date | Patent family member(s) | | Publication date |
|---|---|---|---|---|---|
| WO 2020193039 | A1 | 01-10-2020 | CN 113632013 A | | 09-11-2021 |
| | | | KR 20210129699 A | | 28-10-2021 |
| | | | NL 2024986 A | | 30-09-2020 |
| | | | US 2022187722 A1 | | 16-06-2022 |
| | | | WO 2020193039 A1 | | 01-10-2020 |
| KR 20060025459 | A | 21-03-2006 | NONE | | |
| WO 2021239461 | A1 | 02-12-2021 | CN 115668068 A | | 31-01-2023 |
| | | | KR 20230013039 A | | 26-01-2023 |
| | | | WO 2021239461 A1 | | 02-12-2021 |
| US 2006061743 | A1 | 23-03-2006 | JP 4322242 B2 | | 26-08-2009 |
| | | | JP 2006114919 A | | 27-04-2006 |
| | | | US 2006061743 A1 | | 23-03-2006 |
| | | | US 2006215161 A1 | | 28-09-2006 |

EPO FORM P0459

For more details about this annex : see Official Journal of the European Patent Office, No. 12/82

**REFERENCES CITED IN THE DESCRIPTION**

**Patent documents cited in the description**

- US 6961116 B, Den Boef
- US 2015261097 A1
- US 2009195768 A

- WO 2021239461 A